# EUROPEAN PATENT SPECIFICATION

(11) **EP 0 251 764 B1**
(45) Date of publication and mention of the grant of the patent: **27.03.1996**
(21) Application number: 87305783.0
(22) Date of filing: 30.06.1987
(51) Int. Cl.: H01L 21/768, C23C 16/44, H01L 21/285

(54) **Chemical vapour deposition methods and apparatus**
Verfahren und Vorrichtung zum Abscheiden aus der Gasphase
Procédé et appareil de dépôt en phase vapeur

(30) Priority: 30.06.1986 JP 152921/86; 18.07.1986 JP 170335/86; 19.07.1986 JP 170280/86
(43) Date of publication of application: 07.01.1988
(73) Proprietor: NIHON SINKU GIJUTSU KABUSHIKI KAISHA, Chigasaki-shi Kanagawa-ken (JP)
(72) Inventor: Kusumoto, Yoshiro, Chigasaki-shi Kanagawa-ken (JP); Takakuwa, Kazuo, Chigasaki-shi Kanagawa-ken (JP); Ikuta, Tetsuya, Chigasaki-shi Kanagawa-ken (JP); Suzuki, Akitoshi, Chigasaki-shi Kanagawa-ken (JP); Nakayama, Izumi, Sumiredaira Hiratsuka-shi Kanagawa-ken (JP)
(74) Representative: Crisp, David Norman

(56) References cited:
- EP-A- 0 184 352
- EP-A- 0 254 651
- WO-A-86/06755
- FR-A- 2 548 218
- US-A- 4 543 270
- JOURNAL OF THE ELECTROCHEMICAL SOCIETY, vol. 132, no. 11, November 1985, pages 2779-2784, Manchester, New Hampshire, US; Y.PAULEAU et al.: "Kinetics and mechanism of selective tungsten deposition by LPCVD"
- SOLID STATE TECHNOLOGY, vol. 28, no. 12, December 1985, pages 51-59, Port Washington, New York, US; E.L.BROADBENT et al.: "Selective tungsten processing by low pressure CVD"
- RCA REVIEW, vol. 31, no. 2, June 1970, pages 306-316; J.M.SHAW et al.: "Vapor-deposited tungsten as a metallization and interconnection material for silicon devices"
- JOURNAL OF THE ELECTROCHEMICAL SOCIETY, vol. 131, no. 6, June 1984, pages 1427-1433
- IEEE ELECTRON DEVICE LETTERS, vol. EDL-5, no. 2, February 1984, pages 32-35
- JOURNAL OF APPLIED PHYSICS, vol. 58, no. 9, 1 November 1985, pages 3573-3582
- PATENT ABSTRACTS OF JAPAN, vol. 10, no. 4 (C-322)(2061), January 9, 1986 & JP-A-60 166 032

## Description

This invention relates to the selective deposition of a metal on selected areas of a wafer, e.g. a semiconductor wafer, by chemical vapour deposition (CVD).

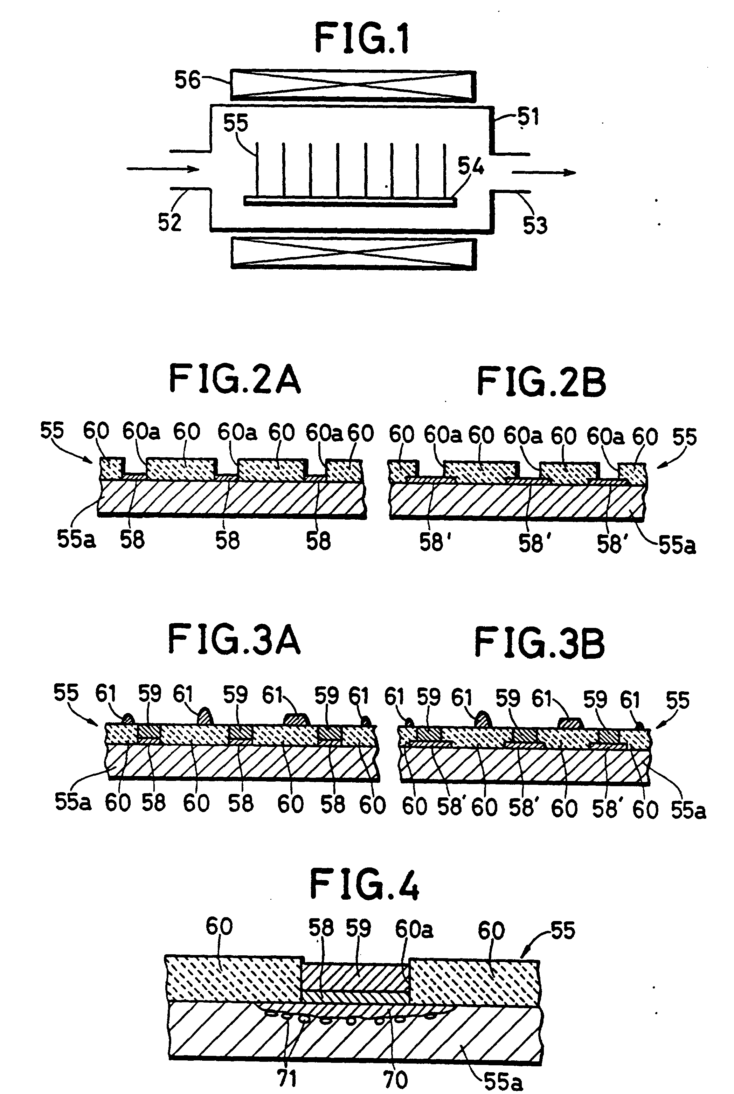

An apparatus used in a previously-proposed CVD method is shown in Figure 1 of the accompanying drawings. Referring to Figure 1, an inlet 52 and an outlet 53 are provided in respective side walls of a horizontal reaction chamber 51 which can be evacuated. A wafer holding plate 54 is horizontally arranged in reaction chamber 51. A plurality of wafers 55 are vertically held at constant spacing by the wafer holding plate 54. An electrical heater 56 is arranged around the reaction chamber 51.

A gas containing, in vapour form, a vapourisable compound of the metal to be deposited, such as tungsten hexafluoride (WF₆), and a reducing gas, such as hydrogen (H₂), are introduced into the reaction chamber 51 through the inlet 52 and exhausted via the outlet 53. The electrical heater 56 heats the reaction chamber 51 and the temperature of the inner wall of the reaction chamber 51 rises. The heat from the inner wall is transmitted through the reaction gases WF₆ and H₂ to the wafers 55. The wafers 55 are thus heated, and the reaction gases WF₆ and H₂ chemically react on the wafers 55. Metallic films are formed on the wafers 55. The reactor used in that type of process is termed a "hot wall" reactor.

Figures 2A and 2B of the accompanying drawings show, in detail, the construction of two different types of wafer 55 that may be used in the above process. In both constructions an insulating film 60 of SiO₂ is formed on the conductive substrate 55a of the wafer 55, with through hole 60a formed in the insulating film 60 to expose the substrate 55a. A first metallic film 58 or 58' of W or Al or aluminium alloy is formed in each of the through holes 60a and during the subsequent CVD process the following reactions take place on the surface of the metallic film 58 or 58': $\text{3H₂ → 6H}$$\text{WF₆ + 6H → 6HF + W}$

Generally, the growth rate of the deposited metal film 59 can be expressed by the following equation:${\text{G = A [H}}_{\text{2}} {\text{]}}^{\text{½}} \text{exp (-Ea/kTm)}$ where A represents a positive constant, [H₂] is the hydrogen concentration, Ea is the activation energy, k is Boltzmann's constant, an Tm is the surface temperature of the growing metallic film. Thus, the growth rate G of the deposited film increases with the surface temperature Tm.

In the above-described CVD method, the surface temperature Tm of the first metallic film 58 or 58' in the through holes 60a and the surface temperature Ti of the insulating film 60 are nearly equal. Moreover, the insulating film surface temperature Ti increases with the metallic film surface temperature Tm with the result that, at high deposition temperatures, metallic films 58, 58' and 59 of W are formed not only in the through holes 60a, but unwanted and disadvantageous metallic nucleations 61 also occur on the insulating film 60, as shown in Figures 3A and 3B.

Also in the case of the type of wafer construction shown in Figure 3A, where the initial film (58) of metal is formed by CVD directly onto the surface of the wafer substrate, as opposed to being a preformed insert (Fig. 3B), the deposited metal encroaches the interface between the substrate 55a (which may generally be of silicon) and the insulating film 60. Thus, an encroachment 70 is formed as shown in Fig. 4 which, in some cases, may also contain voids 71 in the surface of the substrate.

Such encroachment is believed to be promoted by turbulent flow of the reaction gases or natural convection in the vicinity of the wafer 55 . However, the only internal control parameters for the method are the pressure and flow rate of the reaction gas. Accordingly, it is not possible to control the turbulent flow and natural convection from the outside, and the encroachment and voids cannot be suppressed by these means. Thus, the previously-proposed hot wall reactor method has problems with reproducibility, controllability and uniformity over a wide range of pressure and flow rates.

Additionally in that type of method the reaction gas diffuses throughout the whole of the reaction chamber so that deposits also occur on the inner walls of the reaction chamber and on the inspection window. Moreover additional problems arise from the fact that dust particles are produced in the reaction chamber and appear as impurities in the deposited metal film.

Film formation at low temperature and low concentration has been considered as a way of suppressing the encroachment and voids. However, the growing rate becomes unacceptably low, for example tens of angstroms per minute (Å/min). (Broadbent et al. J. Electrochem. Soc. 131, 1427 (1984); Blewer. VMIC (1985)). As an example, about two hours are required for filling a through or contact hole of 1 µm depth, under these conditions.

In an intervening publication, W086/06755 falling within the terms of Article 54(3) EPC, a method is disclosed for the selective chemical vapour deposition of a metal on metal and semiconductive surfaces of a substrate, e.g. a silicon wafer, by placing the wafer on a wafer support in an elongated reactor, passing a gaseous reaction mixture through the reactor and across the surface of the wafer, and heating the wafer to cause the decomposition of the metal-containing component of the gaseous reaction mixture and the selective deposition of that metal on the metal or semiconductor surfaces of the wafer in preference to the insulating surfaces. A variety of means are disclosed for heating the wafer, including resistance heating of the wafer support member, radio frequency induction heating of a susceptor which then heats the wafer by radiant energy, and direct heating of the wafer by exposure to a radiant energy source emitting radiant energy in the visible and ultra-violet region of the spectrum including radiation of a wavelength of 1 micrometer or less. In preferred examples, but not in comparative examples elaborate measures are taken to isolate the wafer from undesirable impinging radiation and especially impinging undesirable infrared radiation.

The reaction kinetics involved in the selective deposition of tungsten by low-pressure CVD are discussed in detail in J. Electrochem. Soc., 131, No. 6, 1427-1433 (1984) and in Solid State Technology, 28, No. 12, 51-59 (1985) and both show the dependence of the rate of growth of CVD tungsten films on, inter alia, temperature, pressure and film thickness.

It is known from JP-A-60 166 032 to carry out a photochemical deposition method by passing a photochemically reactive gas across the surface of a substrate under conditions of laminar flow and irradiating the gas from an external source to effect the photochemical deposition of the desired deposit on the surface of the substrate. In that case it is known to introduce a stream of inert gas through the reactor in parallel with the reactive gas stream to shield the internal walls of the reactor, and particularly the window through which the radiation enters the reactor, from the reactive gas. That method relies on the chemical decomposition of the gas not thermal.

Lastly, in another intervening publication with an earlier priority date, EP-A-0254651, falling within the terms of Article 54(3) EPC, a CVD method and apparatus is described having many of the characteristic features of the present invention. In particular, in EP-A-0254651, there is disclosed a CVD method in which a mixture of reaction gases is introduced into a reactor in a direction which is substantially parallel to the surface of one or more wafers supported in the reactor on a wafer holder, and so that the reaction gas mixture flows across the surface of the wafer(s) essentially under conditions of laminar flow. Additionally an inert gas stream is introduced downwardly into the reactor perpendicularly to the flow of reaction gas downwardly onto the wafer. But in that case the wafers are heated by a resistance heater incorporated into the wafer holder.

In accordance with a first aspect of the present invention a CVD method is provided for the selective deposit of a metal on a wafer, e.g. a silicon wafer, which provides good selectivity of the deposit and a high rate at which the deposit forms, thus enabling wafers to be produced virtually without any metal nucleation formation on the insulating film, wherein encroachment can almost entirely be prevented from growing under the first metal films or the insulating film, and at improved production rates. Moreover, the method ensures that the risk of contamination in the deposit resulting from impingement of the gaseous reaction mixture on the walls of the reactor and the consequent formation of dust is reduced.

In this first aspect of the present invention, a reactor is used to effect the selective chemical vapour phase deposition of a metal, for example, tungsten, on wafers of the type described with reference to Figs. 3A and 3B, i.e. comprising a metal insert preformed in the holes in the insulating layer formed on the surface of the semiconductor, e.g. silicon, substrate. The selective deposition of the metal on top of those preformed metal inserts is achieved by placing the wafer on a support in the reaction chamber, evacuating the chamber, passing the reaction gas mixture through the reaction chamber and across the surface of the wafer under conditions of laminar flow, and irradiating the wafer with infrared radiation from an external or internal infrared lamp, thereby to achieve selectively differential heating of the preformed metal inserts in said through holes by virtue of the different infrared absorption rates of the preformed metal inserts as compared with the surrounding insulating layer and the selective deposition of the metal on those metallic inserts. During the reaction the stream of reaction gas is maintained in contact with the wafer and away from the internal surfaces of the reactor by injecting a stream containing an inert gas into the reactor in a direction substantially perpendicular to the direction of flow of the reaction gas through the reactor and substantially perpendicularly towards the surface of the wafer, thereby deflecting the stream of reaction gas into contact with the surface of the wafer and substantially preventing diffusion of the reaction gas upwardly in the reactor. In that way dust formation is minimised as are deposits on the internal surfaces of the reactor.

In a modified version of the above method, the wafer is heated by means of a resistance heater incorporated into the wafer holder, rather than by means of an infrared lamp.

In yet another variant, the wafer is supported on a holder that is transparent to infrared radiation and is heated by an internal or external infrared lamp which directs infrared radiation onto the wafer through the holder.

Thus the present invention provides CVD methods in which a second metallic film is formed on top of a first metallic film formed in the through holes of the insulating film on a substrate of a wafer, with good quality and with good selective formation of the second metallic film and wherein the creation of dust particles is prevented, so that the inner wall of the reaction chamber and the observation window are protected from contamination.

In a further aspect of the invention, there is also provided chemical vapour deposition apparatus comprising an evacuatable reaction chamber having gas inlet(s) for the admission of a reaction gas to the chamber and a gas outlet for the discharge of unreacted gas from the chamber, a wafer holder positioned in said chamber for supporting a wafer in a position to be contacted by the said reaction gas as it flows through the reaction chamber from the inlet to the outlet, and heating means for heating the wafer as the said reaction gas flows through the reaction chamber in contact with the said wafer thereby to effect the chemical vapour phase deposition of the reaction gas in the reaction chamber (1) and the formation of a deposit on the exposed surface(s) of the wafer, wherein the wafer holder provides a flat support surface upon which the wafer rests with a surface exposed to the gas flow through the reaction chamber, the gas inlet(s) are positioned in a wall of the reaction chamber in a position to direct the reaction gas into the reaction chamber in a direction substantially parallel to the surface of the wafer holder (2), a further gas inlet (6) being provided in said reaction chamber (1) in a position to direct a stream of inert gas into the reaction chamber in a direction substantially perpendicular to the surface of the wafer holder thereby to deflect the flow of reaction gas through the reaction chamber from said inlet(s) to said outlet onto the surface of the wafer holder and onto the surface of a wafer positioned thereon, and wherein said heating means is an infrared lamp located externally or internally of the reaction chamber and in a position to direct infrared radiation onto the wafer when supported on the wafer holder.

The invention will now be described by way of example with reference to the accompanying drawings, in which:
Figure 1 is a schematic cross-sectional view of a CVD apparatus according to the prior art;
Figures 2A and 2B are enlarged cross-sectional views of a part of two different types of wafer construction arranged in the CVD apparatus of Figure 1;
Figures 3A and 3B are enlarged partial cross-sectional views of the wafers shown in Figures 2A and 2B respectively;
Figure 4 is a further enlarged partial cross-sectional view of the wafer shown in Figure 3A;
Figure 5 is a schematic cross-sectional view of a CVD apparatus for use in accordance with a first embodiment of the present invention;
Figures 6A and 6B are enlarged cross-sectional views of a wafer arranged in the apparatus shown in Figure 5, the wafers being of the two different types described above with reference to Figures 2A and 2B and 3A and 3B;
Figures 7A and 7B are enlarged cross-sectional views of the parts of the wafer shown in Figures 6A and 6B;
Figures 8A to 8C are schematic cross-sectional views of the apparatus shown in Figure 5 for explaining the gas flow patterns utilised in accordance with the first aspect of the present invention;
Figures 9 to 13 are schematic cross-sectional views of alternative CVD apparatus usable in accordance with the present invention;
Figure 14 is a cross-sectional view taken along the line XIV-XIV in Figure 13;
Figure 15 is a cross-sectional view of yet another CVD apparatus usable in accordance with the present invention;
Figure 16 is a front view of a modification to the gas inlet shown in Figure 5; and
Figure 17 is a front view of another modification to the gas inlet shown in Figure 5.

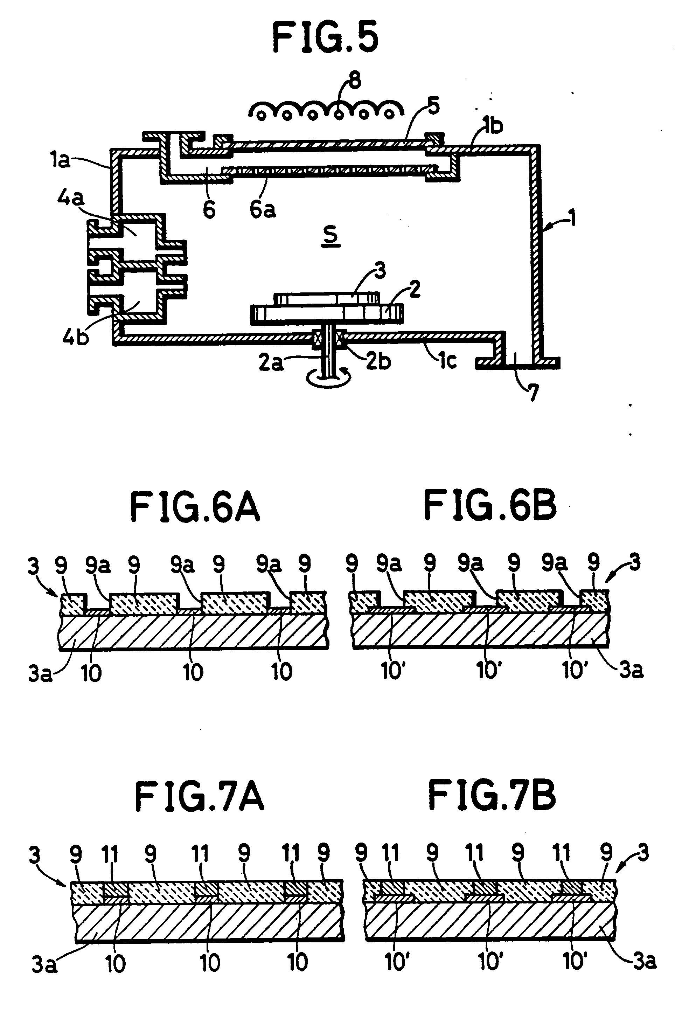

Figures 1 to 4, which relate to the prior art, have already been described. Referring now to Figure 5 which is a schematic view of a CVD apparatus for use in accordance with the first aspect, of the present invention, this apparatus comprises a wafer bolder 2 rotatably arranged in a pressure-reduced reaction chamber 1. A substrate or wafer 3 is held on the wafer holder 2. A shaft 2a is fixed to the wafer holder 2, and is rotatably arid fluid-tightly supported by a bearing 2b which is fixed to a bottom wall 1c of the reaction chamber 1.

Gas inlets 4a and 4b having respective slit-like openings are arranged in one side wall 1a of the reaction chamber 1. A reducing gas, such as H₂, is introduced into the reaction chamber 1 through the inlet 4a, whilst the gas containing the metal to be deposited in the form of a vapourised compound such as WF₆, is introduced through the inlet 4b. The H₂ gas and WF₆ gas together flow across the surface of the wafer 3 under essentially laminar flow conditions promoted by the slit-like inlets 4a and 4b.

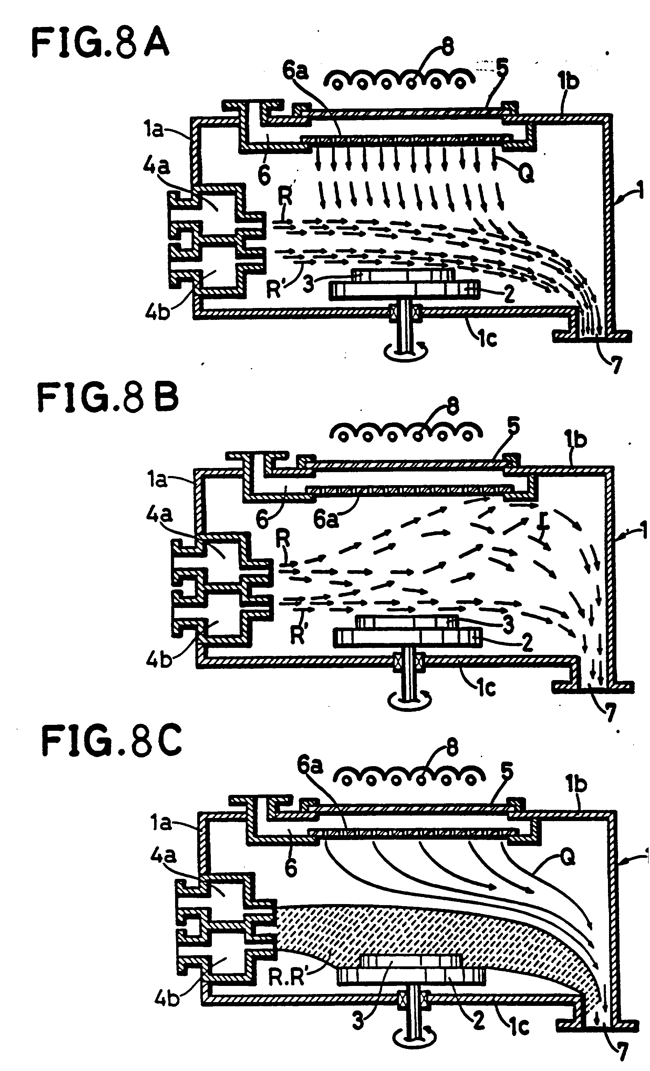

A transparent quartz glass plate 5 and an inert gas inlet 6 are mounted in an upper wall 1b of the reaction chamber 1. Forming part of the inert gas inlet 6 and positioned directly under the transparent quartz glass plate 5 is a perforated gas distribution plate 6a, likewise constructed of quartz, and through which an inert gas such as Ar can be introduced downwardly into the reaction chamber 1 in a direction substantially perpendicular to the stream of the H₂ and WF₆ gases. In this way the H₂ and WF₆ gases are deflected downwardly into contact with the wafer and are prevented from diffusing throughout the rest of the reactor, this gas flow pattern being illustrated more clearly in Figures 8A and 8C.

The H₂, WF₆ and Ar gases are exhausted from the reaction chamber 1 through the gas outlet 7.

A source of infrared radiation such as a lamp 8, is arrange directly above the transparent quartz glass plate 5, outside the reaction chamber 1, to provide infrared radiation impinging directly onto the surface of the wafer 3 through the transparent quartz glass plate 5 and the gas distribution plate 6a.

A CVD method using the above-described apparatus will now be described with reference to Figures 6A to 8C.

Referring firstly to Figure 6A, an insulating film 9 of SiO₂ is deposited on a substrate 3a of Si, and through holes or contact holes 9a are formed in the insulating film 9. First metallic films 10 of W are then preformed in the through holes 9a.

The wafer 3 may alternatively have the construction shown in Figure 6B and in which the first metallic films 10', typically of Al or Al alloy, are formed in the through holes 9a and partially underlying the insulating film 9 of SiO₂.

H₂ reducing gas and the reactive metal-containing gas, WF₆, are introduced into the evacuated reaction chamber 1 through the gas inlets 4a and 4b. Simultaneously the wafer holder 2 supporting the wafers 3 is rotated, and Ar gas is introduced downwardly into the reaction chamber through the gas distribution plate 6a.

Infrared radiation from the infrared lamp 8 is directed on to the surface of the wafer 3 through the transparent quartz glass plate 5 and the transparent gas-distribution plate 6a. Preferably the infrared radiation has a maximum intensity at wavelengths in the range 1.1 to 3 µm.

Within this range, the infrared absorption rate of the metallic film 10 of W is higher than that of either the substrate 3 or the insulating film 9, so that the metallic films 10 of W are preferentially heated by absorption of radiation from the infrared lamp 8. The infrared absorption rate of sillicon, for example, is low for wavelengths greater than 1.1 µm, whilst the infrared absorption rate of SiO₂ is low for wavelengths less than 3µm. A temperature difference is thus obtained between the metallic films 10 of W and the insulating film 9 of SiO₂.

As a result the reactions represented by the following formulae (4) and (5) are effected only on the surfaces of the metallic films 10, virtually without any nucleation formation on the insulating film 9 of SiO₂: $\text{3H₂ → 6H}$$\text{WF₆ + 6H → 6HF + W}$

Turning now in more detail to Figures 8A to 8C which illustrate the first aspect of the invention, i.e. the gas flow pattern through the reactor, H₂ gas is introduced into the space S of the reaction chamber 1, through the slit-like nozzle 4a, and its gas flow is represented by a reference R in Figures 8A to 8C. Simultaneously a reactive gas stream containing vapourised WF₆ is introduced into the space S of the reaction chamber 1, through the slit-like nozzle 4b, the WF₆ gas flow being represented by a reference R¹ in Figures 8A to 8C. Because of the elongated slit-like nozzles 4a and 4b, the H₂ gas stream and the WF₆ gas stream are introduced into the reactor as two essentially planar, two-dimensional gas streams parallel to the surface of the wafer 3. At the same time an inert gas, such as Ar, is introduced downwardly into the reactor from the inert gas distribution plate 6a, its gas flow being represented by a reference Q in Figures 8A to 8C. The gas flow rates R, R' and Q are externally controlled so that the flow rate of the inert gas Q is, for example, three times the flow rate of the reaction gases R and R'.

As will be untderstood from Figure 8A, the flow of the reaction gases R, R' is restricted to the vicinity of the wafer 3, and pass across the surface of the wafer under essentially laminar flow conditions. This is achieved by means of the inert gas Q which contains the reaction gas flows R, R' from above. That stabilising operation has been confirmed by computer simulation, and by practical experiments using titanium tetrachloride to visualise the gas flow pattern.

The flow R, R' of the reaction gases is a macroscopically limited laminar flow, as shown by the hatched area in Figure 8C, the extent or range of which is controlled by the flow of the inert gas Q.

As will be understood from Figure 8B, if there is no inert gas flow Q the reaction gases R, R' will diffuse widely through the region r under turbulent flow conditions, thus contaminating the inner wall of the reaction chamber and the inspection window, as in the previously-proposed method.

However, according to the present invention, the reaction gas flows R and R' are stabilised and limited to the vicinity of the wafer 3 as shown in Figure 8A or Figure 8C. Accordingly, the inner wall of the reaction chamber and the inspection window are protected from contamination. The quality of the metal films 11 formed on the wafer 3 is thus improved, anti the formation of dust particles reduced. Also when the second metal films 11 are formed on the first metal films 10 or 10' (as shown in Figure 7A or Figure 7B), the encroachment 70 and the voids 71 shown in Figure 4 can almost entirely be prevented from growing films 10 or the insulating film 9, in contrast to the previously-proposed method. Accordingly, the yield rate of semiconductor devices made using the wafer 3 can be improved.

Since the reaction gas flows R and R' are made laminar, the method according to this embodiment is superior in controllability and reproducibility. The thickness distribtion of the second metallic film formed on the first metallic Film 10 in the wafer 3, and the depth of the encroachment can be controlled with the flow rate Q of the inert gas.

A theoretical ground for the effects of the gas flows according to this embodiment will now be discussed. There are unclear points concerning the influence of the reaction gas flows on the encroachment. However, the following explanation may be possible.

The silicon reduction reaction, represented by the formula: $\text{WF₆ + 3/2Si → W + 3/2SiF₄}$ is effected also after the initial stage, at which the first encroachment occurs. Therefore, the silicon reduction reaction should not occur when the silicon substrate in the through holes is covered with the preformed metallic film 10, 10'.

It is considered that the reaction gas is supplied onto the wafer 3 through the gaps between the sides of the metallic films 10 or 10' and 11 and the sides of the through holes 9a of the insulating film 9, and slight gaps among the numerous crystal grains of the metallic films 10 or 10' and 11. In order to promote the silicon reduction at the interface between the metallic film and the silicon substrate, the reaction product (SiF₄) should be effectively discharged into the space in the reaction chamber. When a turbulent flow region exists near the surface of the wafer, the reaction product is rapidly discharged and diffused outwardly through the above-described gaps due to pumping operation of the turbulent diffusion. However, when the whole surface of the wafer is covered with the laminar flow, the reaction product is discharged outwardly only by a molecular diffusion phenomenon. When the gaps are sufficiently narrow, the discharging speed is negligibly small in comparison with the discharging due to the turbulent diffusion. It will be understood from the above that the gas flow control in the vicinity of the surface of the wafer has considerable influence on the encroachment.

Comparison experiments were made under the same growth temperature, total pressure and partial pressure of the reaction gas in the two cases when the reaction gas flows R and R' are made laminar by the inert gas flow Q, and when the reaction gas flows R and R' are not made laminar. Tungsten hexafluoride WF₆ and hydrogen H₂ were used as the reaction gases, and argon Ar was used as the inert gas, as above-described.

First, two wafers were prepared. In the respective wafers, an insulating film of SiO₂ is deposited on a substrate of Si, and a through hole or contact hole is made in the insulating film. The substrate surface is exposed in the through hole.

Tungsten hexafluoride WF₆ and argon Ar were used as the reaction gas and the inert gas, respectively. The first metallic film of W was formed to a depth of about a few hundred angstroms Å in the through hole, at a growth temperature of 400°C under a total pressure of about 93 Pa (0.7 Torr). One of the two wafers was taken out from the reaction chamber. The cross-section was observed by a scanning electron microscope with respect to formation of the encroachment.

Then, Wf₆ and H₂ reaction gases and Ar inert gas were introduced into the reaction chamber. The second film of W was formed on the first film of W in the remaining wafer under the same conditions as above-described. Similarly, the cross-section after the formation of the second film was observed by the scanning electron microscope with respect to the development of the encroachment.

The same experiment as described above was made for the case t hat the inert gas was not used. As a result, it was confirmed that the development of the encroachment on the formation of the second film was significantly less in the case of using the inert gas flow Q, than in the case of using no inert gas flow Q. Further, from the film formation experiments under widely different conditions, it was confirmed that the suppressing effect of the encroachment by the above-described laminarisation functions was a parameter independent of the growth temperature and pressure.

In the above-described embodiment, H₂ and WF₆ are used respectively for the reduction gas and the gas containing a metallic element. However, the described method is not limited to these particular gases. For example, MoF₆, TaF₅, CrF₄, TiF₄, TiCl₄, MoCl₅, WCl₆, AlCl₃ and the like may instead be used for the metallic element containing gas. Further, in the above-described embodiment, SiO₂ is used for the insulating film 9. As an alternative, for example, an oxide such as Al₂O₃, BSG (Borosilicate glass), PSG (Phosphosilicate glass) and BPSG (Borophosphosilicate glass), a nitride such as BN or SiNₓ, or a chemical compound such as SiNₓO_{y} may be used for the insulating film, x and y representing numerals.

Further in the above embodiment, the first metallic films are made of W. Alternatively, for example, the first metallic films may be made of a different metal such as Mo, Ta, Cr, Ti, Al, Pt, Pd, Au, Ni, or an alloy of two or more of these metals (possibly including W).

Further, the first metallic films may be made of a metal silicide such as WSiₓ, TiSiₓ MoSiₓ and PtSiₓ, or a metal nitride such as TiN (x representing a numeral).

Further in the above embodiment, the second metallic films are made of W. Alternatively, for example, the second metallic films may be made of a different metal such as Mo, Ta, Cr, Ti, Al, or an alloy of two or more of these metals (possibly including W).

The metal element of the first metallic film may be either the same as that of the second metallic film, or may be different from that of the Latter.

Further in the above embodiment, the substrate 3a is made of Si. Alternatively, for example, it may be made of SiO₂, Al₂O₃, glass or sapphire.

Further in the above embodiment, the maximum intensity of the infrared lamp 8 is obtained at a wavelength between 1.1 and 3 µm. Alternatively, an infrared lamp exhibiting a maximum intensity of radiation components at a wavelength between 0.75 and 5 µm may be used.

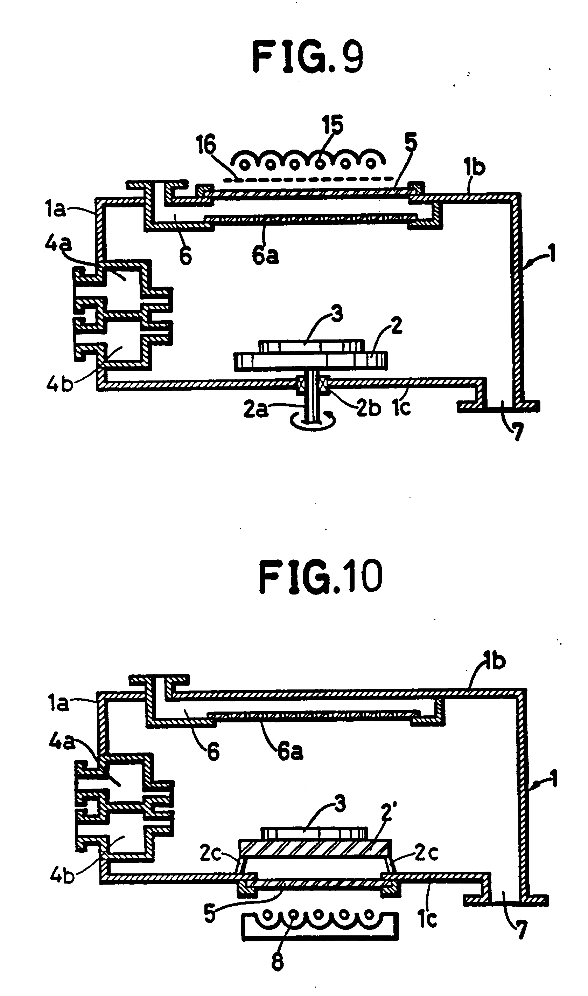

Figure 9 shows a CVD apparatus according to a second embodiment of this invention. Parts in Figure 9 which correspond to those in Figure 5 are denoted by the same reference numerals.

Referring to Figure 9, heating source such as a lamp 15 is used with an optical filter 16 interposed between the heating lamp 15 and the transparent quartz glass plate 5. Light components passing through the optical filter 16 from the heating lamp 12 exhibit a maximum intensity at wavelengths of 0.75 to 5 µm. The same operation as described with reference to the first embodiment is performed for the wafer 3, and the same effects can be obtained for the wafer 3.

Figure 10 shows a CVD apparatus according to a third embodiment of this invention. Parts in Figure 10 which correspond to those in Figure 5 are denoted by the same reference numerals.

Referring to Figure 10, the infrared source or lamp 8 is arranged under a wafer holder 2' which is made of transparent quartz glass. The transparent quartz glass plate 5 is fixed to the bottom wall 1c in contrast to the first embodiment of Figure 5. The wafer holder 2' is fixed to the bottom wall 1c by support members 2c. The same operations as described with reference to the first embodiment are performed for the wafer 3, and the same effects can be obtained for the wafer 3.

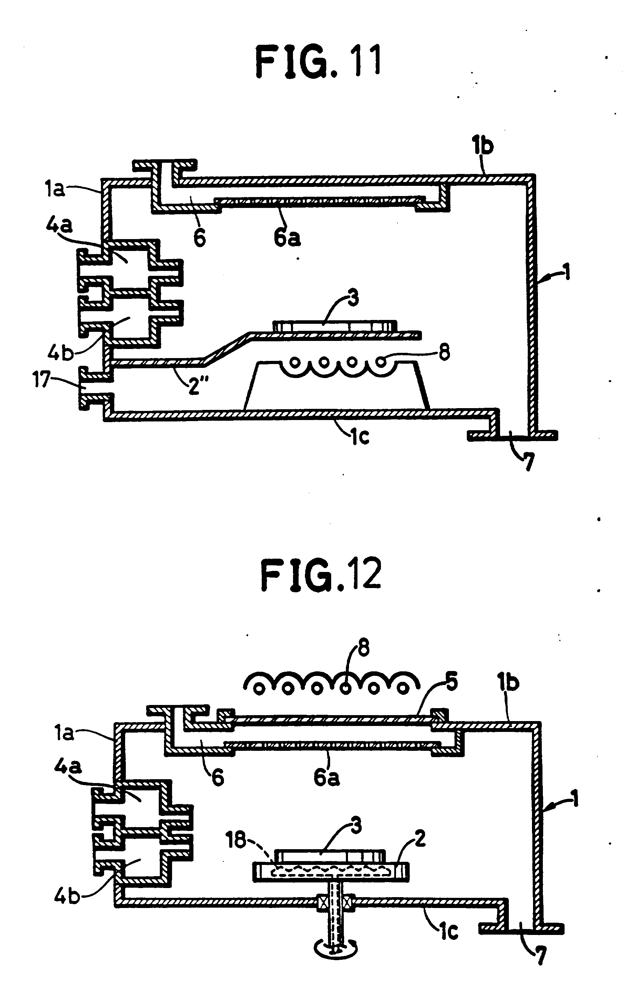

Figure 11 shows a CVD apparatus according to a fourth embodiment of this invention. Parts in Figure 11 which correspond to those in Figure 5 are denoted by the same reference numerals.

Referring to Figure 11, the infrared lamp 8 is arranged under a wafer holder 2" inside the reaction chamber 1. The wafer holder 2" is made of transparent quartz glass plate, and it is fixed to the side wall 1a of the reaction chamber 1. Further, an inert gas introducing inlet 17 is made in the side wall 1a of the reaction chamber 1. The inert gas from the inlet 17 flows through the space between the wafer holder 2" and the infrared lamp 8, and it is discharged from the outlet 7. The reaction products are prevented from adhering on to the infrared lamp 8 and the wafer holder 2" by the flow of the inert gas from the inlet 17. The same operations as described with reference to the first embodiment are performed for the wafer 3, and the same effects can be obtained for the wafer 3.

Figure 12 shows a CVD apparatus according to a fifth embodiment of this invention. Parts in Figure 12 which correspond to those in Figure 5 are denoted by the same reference numerals.

Referring to Figure 12, the wafer holder 2 is provided with a heater 18. The wafer 3 is heated also by the heater 18. The same operations as described with reference to the first embodiment are performed for the wafer 3, and the same effects can be obtained for the wafer 3.

In the above embodiments, a heating lamp or infrared lamp is used. Hereafter, embodiments without a lamp will be described, by which a wafer with high quality can also be obtained, particularly with respect to reduced encroachment and voids.

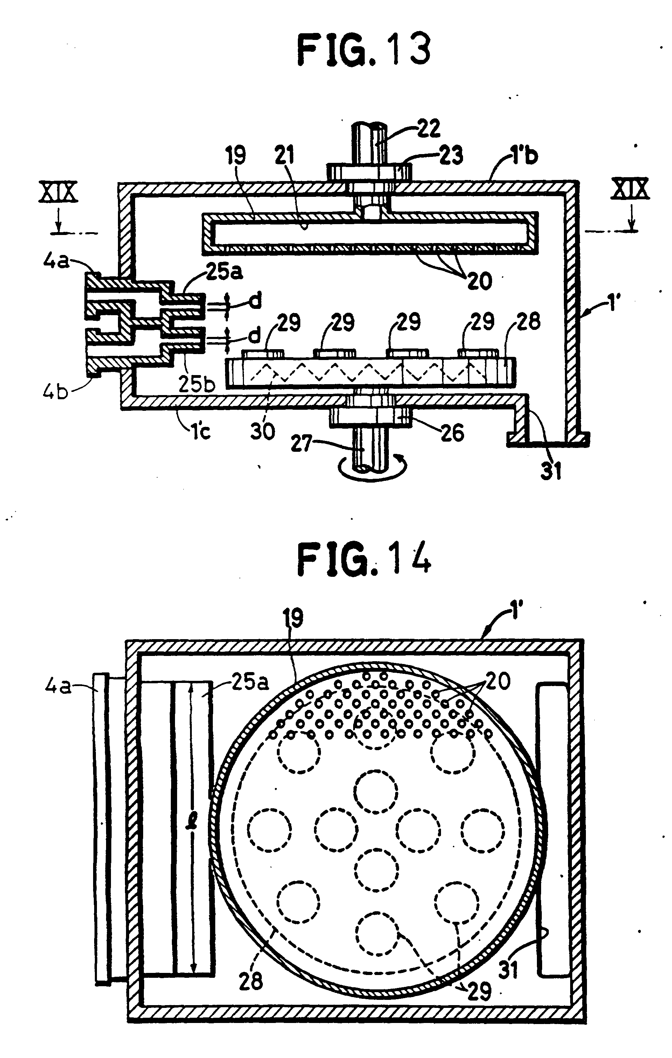

Figure 13 and Figure 14 show a CVD apparatus according to a sixth embodiment of this invention. Parts in Figure 13 which correspond to those in Figure 5 are denoted by the same reference numerals. The gas introducing port ions 4a and 4b will be described in more detail in this embodiment, although they have the same construction as in Figure 5.

The gas introducing portions 4a and 4b have nozzle portions 25a and 25b with slit-like openings. Under levels of the nozzle portions 25a and 25b, a circular wafer holder 28 is rotatably arranged in a reaction chamber 1'. A rotary shaft 27 passing fluid-tightly through a seal member 26 is fixed to the centre of the wafer holder 28. The wafer holder 28 is rotated at a predetermined speed. (The wafer holder 2 in the first embodiment is similarly rotated.) A discharge outlet 31 is formed in the bottom wall 1'c of the redaction chamber 1'.

The wafer holder 28 includes a heater 30. A plurality of waferhs 29 are mounted on the wafer holder 28, and they are heated by the heater 30. The wafers 29 have the same construction as the wafer 3 described in the first embodiment, that is as shown in either Figure 6A or Figure 6B.

An inert gas distribution plate 19 is arranged directly above the wafer holder 28, and it has a hollow portion 21. A pipe 22 passes fluid-tightly through a seal member 23 fixed to the upper wall 1b of the reaction chamber 1', and it communicates with the hollow portion 21. An inert gas such as Ar is supplied via the pipe 22. Numerous small openings 20 are made in the inert gas distribution plate 19, through which the inert gas is ejected downwardly.

The nozzle portions 25a and 25b extend substantially in parallel with the upper surface of the wafer holder 28. Also, the slit-like openings thereof extend substantially in parallel with the upper surface of the wafer holder 28. The width d of the nozzle portions 25a and 25b is sufficiently small in comparison with the length 1 of the slit-like openings thereof. The reaction gases are ejected from the nozzle openings at a flow rate corresponding to a Reynold number larger than 10. The distance between the level of the nozzle portions 25a and 25b and the surface of the wafer holder 28 is so designed as to be nearly equal to 40% of the distance between the inert gas distribution plate 19 and the upper surface of the wafer holder 28. Although the widths d of the nozzle portions 25a and 25b are in practice very small, they are exaggerated in the drawings for better clarity. The nozzle portions 25a and 25b may alternatively be made as one common nozzle portion, and the react ion gases H₂ and WF₆ may be mixed before being ejected from the one common nozzle portion.

In operation, the inert gas is ejected downwardly from the inert gas distribution plate 19, and the reaction gases are ejected horizontally from the nozzle portions 25a and 25b. The gas flow effect described with reference to the first embodiment, as shown in Figures 8A to 8C, can also be obtained in this embodiment. The second metallic film is deposited on the first metallic film with good quality, particularly with respect to encroachment and voids.

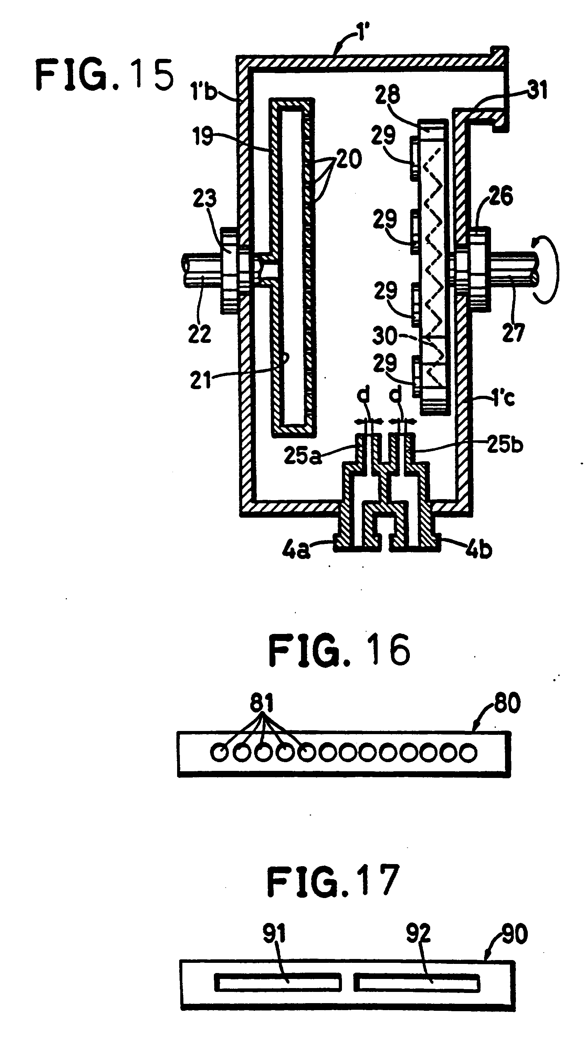

Figure 15 shows a seventh embodiment. Parts in Figure 15 which correspond to those in Figure 13 are denoted by the same reference numerals. The whole reaction chamber 1' of this embodiment is angularly displaced by 90 degrees in comparison with that of the previous embodiments.

Variations to the above-described embodiments may be made, for example as outlined in the following.

For example, in the above embodiments, the gas introducing portions 4a and 4b have slit-like openings. Instead, a flat hollow pipe 80 as shown in Figure 16 may be used. Numerous small openings 81 are provided in the front wall of the pipe 80. A mixed gas of WF₆ and H₂ is ejected from the openings 81. Alternatively, a flat hollow pipe 90 as shown in Figure 17 may be used, having two slits 91 and 92 made along the same horizontal line, in the front wall.

Further, in the embodiment of Figure 5, a plate having numerous small openings is used for the inert gas distribution plate 6a. Instead, a transparent strainer with a suitable aspect ratio or a transparent honeycomb may be used.

Further in the above embodiments, inert gas is used to provide the gas flow towards the surface of the wafer. Instead, an inert gas containing a partially reactive gas may be used. In this case, it is necessary that the reactive gas should not make dust particles. For example, the reactive gas may be H₂ or O₂.

## Claims

1. A method of selectively depositing a metal in a hole or holes (9a) on a wafer (3) and provided thereon by through hole(s) in an insulating film (9) formed on the surface of a wafer substrate (3a), by chemical vapour deposition in a reactor by the steps of placing the wafer (3) on a wafer holder (2) in a reaction chamber (1), evacuating the reaction chamber, feeding to the evacuated reaction chamber and across the surface of the wafer a reaction gas mixture (R, R') containing, in admixture, a metal-containing gas and a reducing gas capable of reacting with the metal-containing gas to deposit the metal in said through hole(s), and exposing the wafer, whilst supported in said chamber on said holder, to a source of infrared radiation thereby to heat the wafer (3) and cause the metal to deposit substantially only in said hole(s) (9a), by virtue of the reaction of the metal-containing gas and the reducing gas in said holes, wherein
(a) the through hole(s) (9a) has or have a metallic film (10, 10') formed therein on the underlying surface of the wafer substrate (3a), said metallic film(s) (10, 10') being preferentially heated by said infrared radiation by virtue of the different infrared absorption rates of the metallic film(s) (10, 10') and the surrounding insulating film (9) thereby to effect the selective deposition of a further layer of metal on top of the preformed metallic film(s) (10,10');
(b) the source of infrared radiation is an infrared lamp (8, 15) positioned internally or externally of the reactor (1); and
(c) the gaseous reaction mixture (R, R') flows in the reaction chamber (1) in a direction substantially parallel to the surface of the wafer so as to provide a substantially laminar flow of reaction gas across the surface of the wafer, and wherein an inert gas stream (Q), optionally containing a partially reactive gas, is directed into the reaction chamber (1) substantially perpendicularly to the direction of flow of the reaction gas mixture (R, R') through the chamber and substantially perpendicularly towards the surface of the wafer holder (2) thereby to maintain the laminar flow of reaction gas across and in contact with the wafer(s) (3) supported on the wafer holder (2) and to substantially prevent diffusion of the reaction gas mixture upwardly in the reaction chamber.

2. A method according to claim 1, characterised in that the infrared lamp provides a source of infrared radiation which is most intensive in the wavelength range 0.75 to 5 µm.

3. A method according to claim 1 or 2, characterised in that the said infrared lamp (8, 15) is located externally of the reaction chamber (1) and positioned to direct said infrared radiation onto the wafer holder (2) via an infrared transparent window (5) located in a wall (1b) of the reaction chamber directly opposite the wafer holder (2).

4. A method according to claim 3, wherein an infra red filter (16) is positioned between the external infrared lamp (15) and said window (5), such filter serving to restrict the infrared radiation directed into the reaction chamber (1) and onto the wafer(s) (3) supported by the wafer holder (2) to wavelengths in the range 0.75 to 5 µm.

5. A method according to any one of claims 1 to 4, characterised in that the wafer(s) (3) is or are additionally heated by a resistance heater (18) incorporated into the wafer holder (2).

6. A method of selectively depositing a metal in a hole or holes (9a) on a wafer (3) and provided thereon by through hole(s) in an insulating film (9) formed on the surface of a wafer substrate (3a), by chemical vapour deposition in a reactor by the steps of placing the wafer (3) on a wafer holder (2) in a reaction chamber (1), evacuating the reaction chamber, feeding to the evacuated reaction chamber and across the surface of the wafer a reaction gas mixture (R, R') containing, in admixture, a metal-containing gas, and a reducing gas capable of reacting with the metal-containing gas to deposit the metal in said through hole(s), and heating the wafer, whilst supported in said chamber on said holder, thereby to deposit the metal substantially only in said hole(s) (9a) by virtue of the reaction of the metal-containing gas and the reducing gas in said holes, wherein
(a) the through hole(s) (9a) has or have a metallic film (10, 10') formed therein on the underlying surface of the wafer substrate (3a), said metallic film(s) (10, 10') being exposed to the reaction gas mixture for the selective deposition of a further layer of metal directly onto said metallic film(s) (10, 10'), and wherein
(b) the gaseous reaction mixture (R, R') flows in the reaction chamber (1) in a direction substantially parallel to the surface of the wafer so as to obtain a substantially laminar flow of reaction gas across the surface of the wafer, and wherein an inert gas stream (Q), optionally containing a partially reactive gas, is directed into the reaction chamber (1) substantially perpendicularly to the direction of flow of the reaction gas mixture (R, R') through the chamber and substantially perpendicularly towards the surface of the wafer holder (2) thereby to maintain the laminar flow of reaction gas across and in contact with the wafer (3) supported on the wafer holder (2) and to substantially prevent diffusion of the reaction gas mixture upwardly in the reaction chamber.

7. A method according to claim 6, characterised in that the wafer(s) (3) is or are heated by means of a resistance heater (30) incorporated in the wafer holder (2).

8. A method according to claim 6, characterised in that the wafer holder (2',2") is transparent to infrared radiation and in that the wafer (3) is heated by means of an infrared lamp (8) positioned to direct infrared radiation onto the wafer through the holder (2',2").

9. A method according to claim 8, characterised in that the wafer (3) is heated by means of an infrared lamp (8) mounted externally of the reaction chamber (1) and in a position to direct infrared radiation onto the wafer (3) through the wafer holder (2') via an infrared transparent window (5) located in the wall (lc) of the reaction chamber (1).

10. A method according to claim 8, characterised in that the infrared lamp (8) is mounted in the reaction chamber (1).

11. A method according to claim 10, characterised in that a second inert gas stream (17) is caused to flow between the infrared lamp (8) and the wafer holder (2") to shield the infrared lamp from the mixture of reaction gases (R,R').

12. A method according to any one of claims 1 to 11, wherein the metallic element of the metallic film(s) (10) formed in said through hole(s) (9a) is the same as the metallic element that is subsequently deposited thereon by said chemical vapour phase deposition.

13. A method according to any one of claims 1 to 11, wherein the metallic element of the metallic film(s) (10) formed in said through hole(s) (9a) is different from the metallic element that is subsequently deposited thereon by said chemical vapour phase deposition.

14. A method according to any one of the preceding claims, wherein said reducing gas is H₂, and the metal-containing gas is one or more of WF₆, MoF₆, TaF₅, CrF₄, TiF₄, TiCl₄, MoCl₅, WCl₆ and AlCl₃.

15. A method according to any one of the preceding claims, wherein said insulating film (9) is one or more of SiO₂, Al₂O₃, oxides of BSG, PSG or BPSG, BN, SiNₓ, or SiNₓO_{y}.

16. A method according to any one of claims 1 to 15, wherein the metallic film (10) formed in said holes is one or more of W, Mo, Ta, Cr, Ti, Al, Pt, Pd, Au, Ni, or an alloy of two or more of the foregoing.

17. A method according to any one of claims 1 to 15, wherein the metallic film (10) formed in said holes is one or more of WSiₓ, TiSiₓ, TaSiₓ, MoSiₓ, PtSiₓ, or TiN.

18. A method according to any one of the preceding claims, wherein said substrate (3a) of the wafer (3) is made of Si, SiO₂, Al₂O₃, glass or sapphire.

19. A method according to any one of the preceding claims, wherein the wafer holder (2) is rotated during the chemical vapour phase deposition of said metal onto the wafer supported thereon.

20. Chemical vapour deposition apparatus comprising an evacuatable reaction chamber (1) having gas inlet(s) (4a, 4b) for the admission of a reaction gas to the chamber and a gas outlet (7) for the discharge of unreacted gas from the chamber, a wafer holder (2) positioned in said chamber (1) for supporting a wafer (3) in a position to be contacted by the said reaction gas as it flows through the reaction chamber (1) from the inlet (4a, 4b) to the outlet (7), and heating means (8) for heating the wafer (3) as the said reaction gas flows through the reaction chamber (1) in contact with the said wafer (3) thereby to effect the chemical vapour phase deposition of the reaction gas in the reaction chamber (1) and the formation of a deposit on the exposed surface(s) of the wafer, wherein the wafer holder (2) provides a flat support surface upon which the wafer (3) rests with a surface exposed to the gas flow through the reaction chamber, the gas inlet(s) (4a, 4b) are positioned in a wall (1a) of the reaction chamber (1) in a position to direct the reaction gas into the reaction chamber in a direction substantially parallel to the surface of the wafer holder (2), a further gas inlet (6) being provided in said reaction chamber (1) in a position to direct a stream of inert gas into the reaction chamber (1) in a direction substantially perpendicular to the surface of the wafer holder (2) thereby to deflect the flow of reaction gas through the reaction chamber (1) from said inlet(s) (4a, 4b) to said outlet (7) onto the surface of the wafer holder (2) and onto the surface of a wafer (3) positioned thereon, and wherein the said heating means (8) is an infrared lamp (8, 15) located externally or internally of the reaction chamber (1) in a position to direct infrared radiation onto the wafer (3) when supported on said holder (2).

21. Apparatus according to claim 20, characterised in that the infrared lamp (8, 15) provides a source of infrared radiation which is most intensive in the wavelength range of from 0.75 to 5µm.

22. Apparatus according to claim 20 or 21, characterised in that the infrared lamp (15) is located externally of the reaction chamber (1) and is positioned to direct infrared radiation onto the wafer holder (2,2',2") via an infrared transparent window (5) located in a wall (1b,1c) of the reaction chamber directly opposite the wafer holder (2, 2', 2").

23. Apparatus according to claim 20 or 21, characterised in that the wafer holder (2',2") is transparent to infrared radiation, and in that the infrared lamp (8) is positioned to direct infrared radiation onto the wafer(s) (3) through the wafer holder (2',2").

24. Apparatus according to any one of claims 20 to 23, characterised in that a resistance heater (18) is incorporated into the wafer holder (2) to provide additional heating of the wafer.

25. Apparatus according to any one of claims 20 to 24, characterised in that the inert gas inlet (6) comprises a gas distribuion plate (6a) having a plurality of small through holes for distributing the inert gas over the whole area of the plate.

26. Apparatus according to any one of claims 20 to 25, characterised in that the wafer holder (2) provides a horizontal support surface for the wafer (3), the reaction gas inlet(s) (4a, 4b) are in a sidewall (1a) of the reaction chamber (1) to provide a flow of reaction gas horizontally across that horizontal support surface and the inert gas inlet (6) is in an upper wall (1b) of the reactor and positioned therein to direct the flow of inert gas downwardly onto that horizontal support surface, and onto the wafer (3) positioned thereon.

## Patentansprüche

1. Verfahren zum gezielten Abscheiden eines Metalls in einem Loch oder in Löchern (9a) auf einem Wafer (3), welche(s) auf diesem in Form eines Durchgangsloches bzw. -löchern in einem Isolierfilm (9) vorgesehen sind, welcher auf der Oberfläche eines Wafersubstrates (3a) ausgebildet ist, durch chemische Dampfabscheidung in einem Reaktor mit den Schritten, daß der Wafer (3) auf einem Waferhalter (2) in einer Reaktionskammer (1) angeordnet wird, die Reaktionskammer evakuiert wird, der evakuierten Reaktionskammer und über der Oberfläche des Wafers eine Reaktionsgasmischung (R, R') zugeführt wird, die in Form einer Beimengung ein Metall enthaltendes Gas und ein reduzierendes Gas enthält, das in der Lage ist, mit dem das Metall enthaltenden Gas das Metall in dem Durchgangsloch (-löchern) abzuscheiden, und daß der Wafer, während er in der Kammer auf dem Halter gehaltert wird, einer Quelle von Infrarotstrahlung ausgesetzt wird, um dadurch den Wafer (3) zu erhitzen und um zu bewirken, daß sich das Metall im wesentlichen nur in dem Loch bzw. in den Löchern (9a) abscheidet, unter der Reaktion des das Metall enthaltenden Gases und des reduzierenden Gases in diesen Löchern, wobei
a) das Durchgangsloch (-löcher) (9a) einen darin ausgebildeten Metallfilm (10, 10') auf der darunterliegenden Fläche des Wafersubstrates (3a) hat, wobei der metallische Film (Filme) (10, 10') durch die Infrarotstrahlung vorzugsweise geheizt wird aufgrund der unterschiedlichen Infrarotabsorptionsraten des metallischen Filmes (der Filme) (10, 10') und des umgebenden isolierenden Filmes (9), um dadurch die gezielte Abscheidung einer weiteren Metallschicht oben auf dem vorher ausgebildeten Metallfilm (den Filmen) (10, 10') zu bewirken;
b) die Quelle von Infrarotstrahlung eine Infrarotlampe (8, 15) ist, die innerhalb oder außerhalb des Reaktors (1) angeordnet ist, und
c) die gasförmige Reaktionsmischung (R, R') in die Reaktionskammer (1) in einer Richtung strömt, die im wesentlichen zu der Oberfläche des Wafers parallel ist, so daß eine im wesentlichen laminare Strömung des Reaktionsgases über die Oberfläche des Wafers bereitgestellt wird, und wobei ein inerter Gasstrom (Q), der wahlweise ein teilweise reaktives Gas enthält, in die Reaktionskammer (1) ) im wesentlichen senkrecht zur Strömungsrichtung der Reaktionsgasmischung (R, R') in die Reaktionskammer (1) und im wesentlichen senkrecht zur Strömungsrichtung der Reaktionsgasmischung (R, R'), durch die Kammer und im wesentlichen senkrecht in Richtung auf die Oberfläche des Waferhalters (2) gerichtet wird, um dadurch die laminare Reaktionsgasströmung über und in Kontakt mit dem Wafer (den Wafern) (3) aufrechtzuerhalten, welche auf dem Waferhalter (2) gehaltert werden, und um eine Diffusion der Reaktionsgasmischung in der Reaktionskammer nach oben im wesentlichen zu verhindern.

2. Verfahren nach Anspruch 1, **dadurch gekennzeichnet, daß** die Infrarotlampe eine Quelle von Infrarotstrahlung bereitstellt, die im Wellenlängenbereich zwischen 0,75 bis 5 µm ihre höchste Intensität hat.

3. Verfahren nach Anspruch 1 oder 2, **dadurch gekennzeichnet, daß** die Infrarotlampe (8, 15) außerhalb der Reaktionskammer (1) angeordnet und so positioniert ist, daß sie die Infrarotstrahlung über ein infrarotdurchlässiges Fenster (5), welches in einer Wand (1b) der Reaktionskammer unmittelbar gegenüber von dem Waferhalter (2) angeordnet ist, auf den Waferhalter (2) richtet.

4. Verfahren nach Anspruch 3, wobei ein Infrarotfilter (16) zwischen der externen Infrarotlampe (15) und dem Fenster (5) angeordnet ist, wobei ein solcher Filter dazu dient, die Infrarotstrahlung, welche in die Reaktionskammer (1) und auf die von dem Waferhalter (2) gehalterten Wafer (3) grichtet wirt, auf Wellenlängen in dem Bereich von 0,75 bis 5 µm zu beschränken.

5. Verfahren nach einem der Ansprüche 1 bis 4, **dadurch gekennzeichnet, daß** der Wafer (die Wafer) (3) zusätzlich durch einen Widerstandsheizer (18), welcher in den Waferhalter (2) eingebaut ist, geheizt wird bzw. werden.

6. Verfahren zum gezielten Abscheiden eines Metalls in einem Loch oder in Löchern (9a) auf einem Wafer (3), welche darauf in Form eines Durchgangsloches bzw. -löchern in einem auf der Oberfläche eines Wafersubstrates (3a) ausgebildeten Isolierfilmes (9) vorgesehen sind, durch chemische Dampfabscheidung in einem Reaktor mit den Schritten, daß der Wafer (3) auf einem Waferhalter (2) in einer Reaktionskammer (1) angeordnet wird, die Reaktionskammer evakuiert wird, der evakuierten Reaktionskammer und auf bzw. über der Oberfläche des Wafers eine Reaktionsgasmischung (R, R') zugeführt wird, die als Beimengung ein ein Metall enthaltendes Gas sowie ein Reduziergas enthält, welches in der Lage ist, mit dem das Metall enthaltenden Gas zu reagieren, um das Metall in dem Durchgangsloch (-löchern) abzuscheiden, und daß der Wafer, während er in der Kammer auf dem Halter gehaltert wird, erhitzt wird, um dadurch das Metall aufgrund der Reaktion des das Metall enthaltenden Gases und des reduzierenden Gases in den Löchern im wesentlichen nur in den Löchern (9a) abzuscheiden, wobei
a) das Durchgangsloch (-löcher) (9a) einen darin ausgebildeten metallischen Film (10, 10') auf der darunterliegenden Oberfläche des Wafersubstrates (3a) hat bzw. haben, wobei der metallische Film (10, 10') für die gezielte Abscheidung einer weiteren Metallschicht unmittelbar auf dem Metallfilm (10, 10') der Reaktionsgasmischung ausgesetzt wird, und wobei
b) die gasförmige Reaktionsmischung (R, R') in die Reaktionskammer (1) in einer Richtung strömt, die im wesentlichen parallel zur Oberfläche des Wafers ist, um so eine im wesentlichen laminare Strömung von Reaktionsgas über die Oberfläche des Wafers zu erhalten, und wobei ein inerter Gasstrom (Q), der wahlweise ein teilweise reaktives Gas enthält, im wesentlichen senkrecht zu der Strömungsrichtung der Reaktionsgasmischung (R, R') durch die Kammer und im wesentlichen senkrecht in Richtung auf die Oberfläche des Waferhalters (2) gerichtet wird, um dadurch die laminare Strömung des Reaktionsgases über den von dem Waferhalter (2) gehalterten Wafer hinweg und in Kontakt mit diesem aufrechtzuerhalten, und um eine Diffusion der Reaktionsgasmischung nach oben in der Reaktionskammer im wesentlichen zu verhindern.

7. Verfahren nach Anspruch 6, **dadurch gekennzeichnet, daß** der Wafer (die Wafer) (3) mit Hilfe eines in den Waferhalter (2) eingebauten Widerstandheizers (30) geheizt wird (werden).

8. Verfahren nach Anspruch 6, **dadurch gekennzeichnet, daß** der Waferhalter (2', 2") für Infrarotstrahlung durchlässig ist und daß der Wafer (3) mit Hilfe einer Infrarotlampe (8) erhitzt wird, die so angeordnet ist, daß sie durch den Halter (2', 2") Infrarotstrahlung auf den Wafer richtet.

9. Verfahren nach Anspruch 8, **dadurch gekennzeichnet, daß** der Wafer (3) mit Hilfe einer Infrarotlampe (8) erhitzt wird, die außerhalb der Reaktionskammer (1) und in einer Position montiert ist, daß sie Infrarotstrahlung auf den Wafer (3) durch den Waferhalter (2') und durch ein infrarotdurchlässiges Fenster (5') hindurch richtet, welches in der Wand (1c) der Reaktionskammer (1) angeordnet ist.

10. Verfahren nach Anspruch 8, dadurch gekennzeichnet, daß die Infrarotlampe (8) in der Reaktionskammer (1) montiert ist.

11. Verfahren nach Anspruch 10, dadurch gekennzeichnet, daß man einen zweiten inerten Gasstrom (17) zwischen der Infrarotlampe (8) und dem Waferhalter (2") strömen läßt, um die Infrarotlampe gegen die Mischung von Reaktionsgasen (R, R') abzuschirmen.

12. Verfahren nach einem der Ansprüche 1 bis 11, wobei das metallische Element des Metallfilmes (der Filme) (10), welcher (welche) in dem Durchgangsloch (-löchern) (9a) ausgebildet wird (werden), dasselbe ist, wie das metallische Element, welches anschließend durch chemische Dampfabscheidung darauf abgeschieden wird.

13. Verfahren nach einem der Ansprüche 1 bis 11, wobei das metallische Element des Metallfilmes (der Filme) (10), welches bzw. welche in dem Durchgangsloch (-löchern) (9a) ausgebildet wird bzw. werden, von dem Metallelement verschieden ist, welches anschließend durch chemische Dampfabscheidung darauf abgeschieden wird.

14. Verfahren nach einem der vorstehenden Ansprüche, wobei das Reduktionsgas H₂ ist und daß das metallenthaltende Gas eines oder mehrere aus der Gruppe WF₆, MoF₆, TaF₅, CrF₄, TiF₄,k TiCl₄, MoCl₅, WCI₆ und AlCl₃ ist.

15. Verfahren nach einem der vorstehenden Ansprüche, wobei der isolierende Film (9) einer oder mehrere aus der Gruppe SiO₂, Al₂O₃, Oxide von BSG, PSG oder BPSG, BN, SiNₓ oder SiNₓO_{y} ist.

16. Verfahren nach einem der Ansprüche 1 bis 15, wobei der metallische Film (10), welcher in den Löchern ausgebildet wird, aus einem oder mehreren der Elemente W, Mo, Ta, Cr, Ti, Al, Pt, Pd, Au, Ni oder einer Legierung aus zwei oder mehreren der vorgenannten Elemente besteht.

17. Verfahren nach einem der Ansprüche 1 bis 15, wobei der in den Löchern ausgebildete metallische Film (10) aus einer oder mehreren der Substanzen WSiₓ, TiSiₓ, TaSiₓ, MoSiₓ, PtSiₓ oder TiN besteht.

18. Verfahren nach einem der vorstehenden Ansprüche, wobei das Substrat (3a) des Wafers aus Si, SiO₂, Al₂O₃, Glas oder Saphir besteht.

19. Verfahren nach einem der vorstehenden Ansprüche, wobei der Waferhalter (2), während der chemischen Dampfphasenabscheidung des Metalles auf dem darauf gehalterten Wafer, gedreht wird.

20. Vorrichtung zur chemischen Dampfabscheidung mit einer evakuierbaren Reaktionskammer (1), welche einen Gaseinlaß (-einlässe) (4a, 4b) für das Einlassen eines Reaktionsgases in die Kammer und einen Gasauslaß (7) für die Abgabe von nichtreagiertem Gas aus der Kammer hat, einem Waferhalter (2), der in der Kammer (1) angeordnet ist, um einen Wafer (3) in einer Position zu halten, in welcher er mit dem Reaktionsgas in Berührung kommt, während dieses durch die Reaktionskammer (1) von dem Einlaß (4a, 4b) zu dem Auslaß (7) strömt, und einer Heizeinrichtung (8) zum Erhitzen des Wafers (3), während das Reaktionsgas durch die Reaktionskammer (1) in Kontakt mit dem Wafer (3) strömt, um dadurch die chemische Dampfphasenabscheidung des Reaktionsgases in der Reaktionskammer (1) und die Ausbildung einer Abscheidung auf der exponierten Fläche (den Flächen) des Wafers zu bewirken, wobei der Waferhalter (2) eine ebene Halterungsfläche bereitstellt, auf welcher der Wafer (3) mit einer dem durch die Reaktionskammer fließenden Gasstrom ausgesetzten Oberfläche ruht, der Gaseinlaß (die Einlässe) (4a, 4b) in einer Wand (1a) der Reaktionskammer (1) in einer Position angeordnet ist bzw. sind, so daß das Reaktionsgas in die Reaktionskammer in einer Richtung gelenkt wird, die im wesentlichen zu der Oberfläche des Wellenhalters (2) parallel ist, ein weiterer Gaseinlaß (6) in der Reaktionskammer (1) in einer solchen Position vorgesehen ist, daß ein Strom aus einem Inertgas in die Reaktionskammer (1) in einer Richtung im wesentlichen senkrecht zur Oberfläche des Waferhalters (2) gerichtet wird, um dadurch den Strom von Reaktionsgas durch die Reaktionskammer (1) von dem Einlaß (den Einlässen) (4a, 4b) zu dem Auslaß (7) auf die Oberfläche des Waferhalters (2) und auf die Oberfläche eines Wafers (3), welcher darauf angeordnet ist, abzulenken, und wobei die Heizeinrichtung (8) eine Infrarotlampe (8, 15) ist, welche außerhalb oder innerhalb der Reaktionskammer (1) in einer Position angeordnet ist, in welcher sie Infrarotstrahlung auf den Wafer (3) richtet, wenn dieser auf dem Halter (2) gehaltert wird.

21. Vorrichtung nach Anspruch 20, **dadurch gekennzeichnet, daß** die Infrarotlampe (8, 15) eine Infrarotstrahlungsquelle bereitstellt, die ihre größte Intensität in dem Wellenlängenbereich zwischen 0,75 und 5 µm hat.

22. Vorrichtung nach Anspruch 20 oder 21, **dadurch gekennzeichnet, daß** die Infrarotlampe (15) sich außerhalb der Reaktionskammer (1) befindet und derart angeordnet ist, daß sie Infrarotstrahlung auf den Waferhalter (2, 2', 2") über bzw. durch ein infrarotdurchlässiges Fenster (5) richtet, welches in einer Wand (1b, 1c) der Reaktionskammer unmittelbar dem Waferhalter (2, 2', 2") gegenüber angeordnet ist.

23. Vorrichtung nach Anspruch 20 oder 21, **dadurch gekennzeichnet, daß** der Waferhalter (2', 2") für Infrarotstrahlung durchlässig ist und daß die Infrarotlampe (8) so angeordnet ist, daß sie Infrarotstrahlung auf den Wafer (die Wafer) (3) durch den Waferhalter (2', 2") hindurch richtet.

24. Vorrichtung nach einem der Ansprüche 20 bis 23, **dadurch gekennzeichnet, daß** ein Widerstandsheizer (18) in den Waferhalter (2) eingebaut ist, um eine zusätzliche Heizung des Wafers bereitzustellen.

25. Vorrichtung nach einem der Ansprüche 20 bis 24, **dadurch gekennzeichnet, daß** der Inertgaseinlaß (6) eine Gasverteilerplatte (6a) aufweist, die eine Mehrzahl von kleinen Durchgangslöchern zum Verteilen des Intertgases über die gesamte Plattenfläche hat.

26. Vorrichtung nach einem der Ansprüche 20 bis 25, **dadurch gekennzeichnet, daß** der Waferhalter (2) eine horizontale Stützfläche für den Wafer (3) hat, daß der Reaktionsgaseinlaß (die Einlässe) (4a, 4b) sich in einer Seitenwand (1a) der Reaktionskammer (1) befindet (befinden), um einen Strom von Reaktionsgas horizontal über diese horizontale Stützfläche hinweg bereitzustellen, und daß der Inertgaseinlaß (6) sich in einer oberen Wand (1b) des Reaktors befindet und darin so angeordnet ist, daß er den Strom von Inertgas nach unten auf diese horizontale Stützfläche und auf den darauf angeordneten Wafer (3) richtet.

## Revendications

1. Procédé pour déposer sélectivement un métal dans un ou plusieurs trous (9a) sur une plaquette (3) produit(s) sur celle-ci par un ou plusieurs trous traversants ménagés dans un film isolant (9) formé à la surface d'un substrat de plaquette (3a), par un dépôt chimique en phase vapeur que l'on effectue dans un réacteur par les étapes consistant à placer la plaquette (3) sur un porte-plaquette (2) dans une chambre de réaction (1), purger la chambre de réaction, envoyer dans la chambre de réaction purgée et au travers de la surface de la plaquette un mélange réactionnel gazeux (R, R') contenant, par admixion, un gaz à teneur métallique et un gaz réducteur pouvant réagir avec le gaz à teneur métallique de façon à déposer le métal dans ledit ou lesdits trous traversants et exposer la plaquette, tandis qu'elle est supportée dans ladite chambre sur ledit porte-plaquette, à une source de rayonnement infrarouge avec pour effet de chauffer la plaquette (3) et d'amener le métal à se déposer sensiblement dans ledit ou lesdits trous (9a) seulement, en raison de la réaction du gaz à teneur métallique et du gaz réducteur dans lesdits trous, dans lequel
(a) le ou les trous traversants (9a) comporte(nt) un film métallique (10, 10') formé dans celui-ci ou dans ceux-ci sur la surface sous-jacente du substrat de plaquette (3a), ledit ou lesdits films métalliques (10, 10') étant de préférence chauffés par ledit rayonnement infrarouge en raison des taux d'absorption différents dans l'infrarouge du ou des films métalliques (10, 10') et du film isolant environnant ce qui permet d'effectuer le dépôt sélectif d'une autre couche métallique au sommet du ou des films métalliques préformés (10, 10') ;
(b) la source de rayonnement infrarouge est une lampe à infrarouge (8, 15) positionnée à l'intérieur ou à l'extérieur du réacteur (1) ; et
(c) le mélange réactionnel gazeux (R, R') s'écoule dans la chambre de réaction (1) suivant une direction sensiblement parallèle à la surface de la plaquette de façon à obtenir un écoulement sensiblement laminaire du gaz réactionnel au travers de la surface de la plaquette, et dans lequel un flux de gaz inerte (Q) contenant de manière facultative un gaz partiellement réactif, est dirigé dans la chambre de réaction (1) de manière sensiblement perpendiculaire à la direction de l'écoulement du mélange réactionnel gazeux (R,R') à travers la chambre et de manière sensiblement perpendiculaire vers la surface du porte-plaquette (2) ceci ayant pour effet de maintenir l'écoulement laminaire du gaz réactionnel au travers de la ou des plaquettes (3) et en contact avec celle ou celles-ci, lesquelles sont supportées par le porte-plaquette (2) et d'empêcher sensiblement la diffusion vers le haut du mélange réactionnel gazeux dans la chambre de réaction.

2. Procédé selon la revendication 1, caractérisé en ce que la lampe à infrarouge constitue une source de rayonnement infrarouge qui est la plus intense dans la gamme des longueurs d'ondes allant de 0,75 à 5 µm.

3. Procédé selon la revendication 1 ou 2, caractérisé en ce que ladite lampe à infrarouge (8, 15) est située à l'extérieur de la chambre de réaction (1) et positionnée de manière à diriger ledit rayonnement infrarouge sur le porte-plaquette (2) au travers d'une fenêtre transparente au rayonnement infrarouge (5) ménagée dans une paroi (1b) de la chambre de réaction directement opposée au porte-plaquette (2).

4. Procédé selon la revendication 3, dans lequel un filtre des infrarouges (6) est positionné entre la lampe à infrarouge (15) externe et ladite fenêtre (5), un tel filtre servant à limiter le rayonnement infrarouge dirigé pour arriver dans la chambre de réaction (1) et sur la ou les plaquettes (3) supportées par le porte-plaquette (2) à des longueurs d'ondes comprises dans la gamme allant de 0,75 à 5 µm.

5. Procédé selon l'une quelconque des revendications 1 à 4, caractérisé en ce que la ou les plaquettes (3) est ou sont, de plus, chauffées par un dispositif de chauffage à résistance (18) incorporé dans le porte-plaquette (2).

6. Procédé pour déposer sélectivement un métal dans un ou plusieurs trous (9a) sur une plaquette (3) produit(s) sur celle-ci par un ou plusieurs trous traversants ménagés dans un film isolant (9) formé à la surface de substrat de plaquette (3) par un dépôt chimique en phase vapeur que l'on effectue dans un réacteur par les étapes consistant à placer la plaquette (3) sur un porte-plaquette (2) dans une chambre de réaction (1), purger la chambre de réaction, envoyer dans la chambre de réaction purgée et au travers de la surface de la plaquette un mélange réactionnel gazeux (R, R') contenant, par admixion, un gaz à teneur métallique et un gaz réducteur pouvant réagir avec le gaz à teneur métallique de façon à déposer le métal dans ledit ou lesdits trous traversants et exposer la plaquette, tandis qu'elle est supportée dans ladite chambre sur ledit porte-plaquette, à une source de rayonnement infrarouge avec pour effet de chauffer la plaquette (3) et d'amener le métal à se déposer sensiblement dans ledit ou lesdits trous (9a) seulement, en raison de la réaction du gaz à teneur métallique et du gaz réducteur dans lesdits trous, dans lequel
(a) le ou les trous traversants (9a) comporte(nt) un film métallique (10, 10') formé dans celui-ci ou ceux-ci sur la surface sous-jacente du substrat de plaquette (3a), ledit ou lesdits films métalliques (10, 10') étant exposés au mélange réactionnel gazeux permettant le dépôt sélectif d'une autre couche de métal directement sur ledit ou lesdits films métalliques (10, 10') et dans lequel,
(b) le mélange réactionnel gazeux (R,R') s'écoule dans la chambre de réaction (1) suivant une direction sensiblement parallèle à la surface de la plaquette de façon à obtenir un écoulement sensiblement laminaire du gaz réactionnel au travers de la surface de la plaquette et dans lequel un flux de gaz inerte (Q) contenant de manière facultative un gaz partiellement réactif, est dirigé dans la chambre de réaction (1) de manière sensiblement perpendiculaire à la direction de l'écoulement du mélange réactionnel gazeux (R,R') au travers de la chambre et de manière sensiblement perpendiculaire vers la surface du porte-plaquette (2) avec pour effet de maintenir l'écoulement laminaire du gaz réactionnel au travers de la plaquette et en contact avec celle-ci (3), laquelle est supportée sur le porte-plaquette (2) et d'empêcher sensiblement la diffusion vers le haut du mélange réactionnel gazeux dans la chambre de réaction.

7. Procédé selon la revendication 6, caractérisé en ce que la ou les plaquettes (3) est ou sont chauffées au moyen d'un dispositif de chauffage à résistance (30) incorporé dans le porte-plaquette (2).

8. Procédé selon la revendication 6, caractérisé en ce que le porte-plaquette (2,2'') est transparent au rayonnement infrarouge et en ce que la plaquette (3) est chauffée au moyen d'une lampe à infrarouge (8) positionnée pour diriger le rayonnement des infrarouges sur la plaquette à travers le porte-plaquette (2, 2').

9. Procédé selon la revendication 8, caractérisé en ce que la plaquette (3) est chauffée au moyen d'une lampe à infrarouge (8) montée à l'extérieur de la chambre de réaction (1) et dans une position permettant de diriger le rayonnement infrarouge sur la plaquette (3) à travers le porte-plaquette (2'), au travers d'une fenêtre transparente au rayonnement infrarouge (3) ménagée dans la paroi (1c) de la chambre de réaction (1).

10. Procédé selon la revendication 8, caractérisé en ce que la lampe à infrarouge (8) est montée dans la chambre de réaction (1).

11. Procédé selon la revendication 10, caractérisé en ce qu'un second flux de gaz inerte (17) est amené à s'écouler entre la lampe à infrarouge (8) et le porte-plaquette (2") afin de protéger la lampe à infrarouge du mélange réactionnel gazeux (R,R').

12. Procédé selon l'une quelconque des revendications 1 à 11, dans lequel l'élément métallique du ou des films métalliques (10) formé dans ledit ou lesdits trous traversants (9) est le même que l'élément métallique qui est déposé par la suite sur celui-ci ou ceux-ci par ledit dépôt chimique en phase vapeur.

13. Procédé selon l'une quelconque des revendications 1 à 11, dans lequel l'élément métallique du ou des films métalliques (10) formé dans ledit ou lesdits trous traversants (9a) est différent de l'élément métallique qui par la suite est déposé sur celui-ci ou sur ceux-ci par ledit dépôt chimique en phase vapeur.

14. Procédé selon l'une quelconque des revendications précédentes, dans lequel ledit gaz réducteur est H₂ et le gaz à teneur métallique est un ou plusieurs des composés WF₆, MoF₆, TaF₅, CrF₄, TiF₄, TiCl₄, MoCl₅, WCl₆ ou AlCl₃.

15. Procédé selon l'une quelconque des revendications précédentes, dans lequel ledit film isolant (1) est un ou plusieurs des composés SiO₂, Al₂O₃, oxydes de BSG, PSG ou BPSG, BN, SiNₓ, ou SiNₓO_{y}.

16. Procédé selon l'une quelconque des revendications 1 à 15, dans lequel le film métallique (10) formé dans ledit trou est un ou plusieurs des éléments W, Mo, Ta, Cr, Ti, Al, Pt, Pd, Au, Ni ou alliage de deux ou plusieurs des éléments cités précédemment.

17. Procédé selon l'une quelconque des revendications 1 à 15, dans lequel le film métallique (10) formé dans lesdits trous est un ou plusieurs des composés WSiₓ, TiSiₓ, TaSiₓ, MoSiₓ, PtSiₓ, ou TiN.

18. Procédé selon l'une quelconque des revendications précédentes, dans lequel ledit substrat (3a) de la plaquette (3) est constitué de Si, SiO₂, Al₂O₃, de verre ou de saphir.

19. Procédé selon l'une quelconque des revendications précédentes, dans lequel le porte-plaquette (2) est mis en rotation pendant le dépôt chimique en phase vapeur dudit métal sur la plaquette supportée sur celui-ci.

20. Dispositif de dépôt chimique en phase vapeur comprenant une chambre de réaction qui peut être purgée (1) comportant un ou des orifices d'entrée de gaz (4a, 4b) permettant l'admission d'un gaz réactionnel dans la chambre et un orifice de sortie de gaz (7) permettant l'évacuation hors de la chambre du gaz n'ayant pas réagi, un porte-plaquette (2) positionné dans ladite chambre (1) destiné à supporter une plaquette (3) en une position de mise en contact avec ledit gaz réactionnel pendant l'écoulement de celui-ci à travers la chambre de réaction (1) de l'orifice d'entrée (4a, 4b) jusqu'à l'orifice de sortie (7), et un moyen de chauffage (8) destiné à chauffer la plaquette (3) pendant l'écoulement dudit gaz réactionnel à travers la chambre de réaction (1) en contact avec ladite plaquette (3) ce qui permet d'effectuer de ce fait le dépôt chimique en phase vapeur du gaz réactionnel dans la chambre de réaction (1) et de former un dépôt sur la ou les surfaces exposées de la plaquette, dans lequel le porte-plaquette (2) comporte une surface de support plate sur laquelle la plaquette (3) repose avec une surface exposée à l'écoulement du gaz à travers la chambre de réaction, le ou les orifices d'entrée de gaz (4a, 4b) est ou sont positionnés dans une paroi (la) de la chambre de réaction (1) en une position permettant de diriger les gaz réactionnels dans la chambre de réaction suivant une direction sensiblement parallèle à la surface du porte-plaquette (2), un orifice d'entrée de gaz (5) supplémentaire étant prévu dans ladite chambre de réaction (1) en une position permettant de diriger un flux de gaz inerte dans la chambre de réaction (1) suivant une direction sensiblement perpendiculaire à la surface du porte-plaquette (2) avec pour effet de dévier l'écoulement du gaz réactionnel à travers la chambre de réaction (1) dudit ou desdits orifices d'entrée (4a, 4b) jusqu'audit orifice de sortie (7) sur la surface du porte-plaquette (2) et sur la surface d'une plaquette (3) positionnée sur celui-ci et dans lequel ledit moyen de chauffage (8) est une lampe à infrarouge (8, 15) située à l'extérieur ou à l'intérieur de la chambre de réaction (1) en une position permettant de diriger le rayonnement infrarouge sur la plaquette (3) lorsque celle-ci est supportée sur le porte-plaquette (2).

21. Dispositif selon la revendication 20, caractérisé en ce que la lampe à infrarouge (8, 15) constitue une source de rayonnement infrarouge qui est la plus intense dans la gamme des longueurs d'onde allant de 0,75 à 5 µm.

22. Dispositif selon la revendication 20 ou 21, caractérisé en ce que la lampe à infrarouge (15) est située à l'extérieur de la chambre de réaction (1) et est positionnée de manière à diriger le rayonnement infrarouge sur le porte-plaquette (2, 2', 2'') au travers d'une fenêtre transparente au rayonnement infrarouge (5) ménagée dans une paroi (1b, 1c) de la chambre de réaction directement opposée au porte-plaquette (2, 2', 2'').

23. Dispositif selon la revendication 20 ou 21, caractérisé en ce que le porte-plaquette (2', 2'') est transparent au rayonnement infrarouge et en ce que la lampe à infrarouge (8) est positionnée de manière à diriger le rayonnement infrarouge sur la ou les plaquettes (3) au travers du porte-plaquette (2', 2'').

24. Dispositif selon l'une quelconque des revendications 20 à 23, caractérisé en ce qu'un dispositif de chauffage à résistance (18) est incorporé dans le porte-plaquette (2) afin de procurer un chauffage supplémentaire de la plaquette.

25. Dispositif selon l'une quelconque des revendications 20 à 24, caractérisé en ce que l'orifice d'entrée du gaz inerte (6) comprend une plaque de distribution de gaz (6a) comportant une pluralité de petits trous traversants pour distribuer le gaz inerte sur la surface totale de la plaque.

26. Dispositif selon l'une quelconque des revendications 20 à 25, caractérisé en ce que le porte-plaquette (2) comporte une surface de support horizontale destinée à la plaquette (3), l'orifice ou les orifices d'entrée du gaz réactionnel (4a, 4b) étant ménagés dans une paroi latérale (1a) de la chambre de réaction (1) afin d'assurer un écoulement du gaz réactionnel s'effectuant horizontalement au travers de cette surface de support horizontale et en ce que l'orifice d'entrée du gaz inerte (6) est ménagé dans une paroi supérieure (1b) du réacteur et y est positionné dans celui-ci afin de diriger l'écoulement du gaz inerte vers le bas sur cette surface de support horizontale et sur la plaquette (3) qui s'y trouve positionnée.
